(19) Europäisches Patentamt
European Patent Office
Office européen des brevets

(11) EP 4 585 624 A1

(12) **EUROPEAN PATENT APPLICATION**
published in accordance with Art. 153(4) EPC

(43) Date of publication:
**16.07.2025 Bulletin 2025/29**

(21) Application number: **23880175.7**

(22) Date of filing: **17.10.2023**

(51) International Patent Classification (IPC):
***C08F 220/34*** (2006.01) ***C08F 226/06*** (2006.01)
***C09J 133/14*** (2006.01) ***H01L 23/29*** (2006.01)
***H10K 59/00*** (2023.01) ***H10K 50/00*** (2023.01)

(52) Cooperative Patent Classification (CPC):
**C08F 220/34; C08F 226/06; C09J 133/14; H01L 23/29; H10K 50/00; H10K 59/00**

(86) International application number:
**PCT/KR2023/016044**

(87) International publication number:
**WO 2024/085598 (25.04.2024 Gazette 2024/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **17.10.2022 KR 20220133526**

(71) Applicant: **Shanjin Optoelectronics (Suzhou) Co., LTD.**
**Suzhou, Jiangsu 215699 (CN)**

(72) Inventors:
- **SHIN, Young Jun**
  **Daejeon 34122 (KR)**
- **KIM, Hyun Cheol**
  **Daejeon 34122 (KR)**

(74) Representative: **Wang, Bo**
**Panovision IP**
**Ebersberger Straße 3**
**85570 Markt Schwaben (DE)**

# (54) POLYMER

(57) The present application can provide a polymer, a cross-linkable composition comprising the same, a method for producing the cross-linkable composition, and a use of the polymer or the cross-linkable composition. The present application can provide a polymer capable of forming a material having an excellent antistatic function, a cross-linkable composition and a production method thereof, and a use thereof. The present application can provide a polymer which can exhibit an antistatic function without adding a separate antistatic agent, does not bleed the ingredient exerting the antistatic function, is easy to store, and can maintain performance of a pressure-sensitive adhesive after being applied to the relevant pressure-sensitive adhesive, and the like, a cross-linkable composition, a production method thereof, and a use thereof.

[Figure 2]

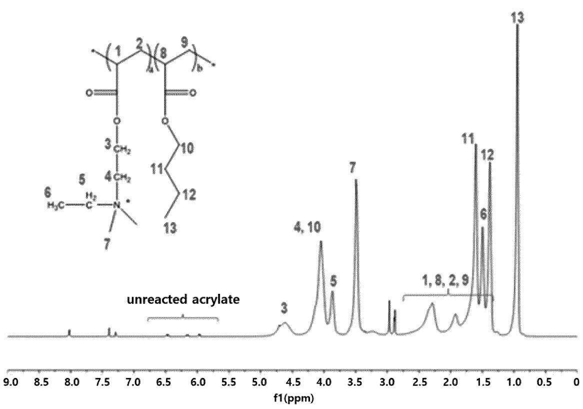


EP 4 585 624 A1

## Description

[Technical Field]

Cross-Reference with Related Applications

This application claims the benefit of priority based on Korean Patent Application No. 10-2022-0133526 dated October 17, 2022, the disclosure of which is incorporated herein by reference in its entirety.

Technical Field

The present application relates to a polymer, a cross-linkable composition comprising the same, a method for producing the polymer, and a use of the polymer or cross-linkable composition.

[Background Art]

Materials with antistatic functions can be applied to various fields. For example, materials with antistatic functions and pressure-sensitive adhesive or adhesive properties are also used in optical devices such as LCDs (liquid crystal displays) and OLEDs (organic light emitting diodes).

The LCD comprises a liquid crystal panel having a liquid crystal layer, and a polarizing plate, where upon attaching the liquid crystal panel and the polarizing plate, a pressure-sensitive adhesive having an antistatic function, and the like may be used. In a device such as OLEDs, a pressure-sensitive adhesive having an anti-static function can also be applied to an OLED panel, and the like.

A general method for producing a material such as a pressure-sensitive adhesive or adhesives having an antistatic function is to mix an antistatic agent with a polymer having pressure-sensitive adhesive properties such as an acrylic polymer, where various ionic compounds, or surfactants, and the like are known as the usable antistatic agent. However, these antistatic agents may cause contamination or the like, or cause a problem such as lifting, bubbles, or peeling by bleeding out from the pressure-sensitive adhesive or adhesive, and the like during use or storage. In addition, the antistatic agent may affect the performance of the pressure-sensitive adhesive or adhesive, particularly worsen reworkability (re-work), and the like of the pressure-sensitive adhesive.

To solve such problems, a technology of directly polymerizing a monomer having an antistatic function, for example, a monomer having ionicity, into an acrylic polymer to form a pressure-sensitive adhesive and the like is also known. In such a method, the monomer having ionicity or the like is introduced thereto directly during the polymerization process, and the polymerization is performed. However, in such a method, since the monomer having ionicity or the like usually has poor affinity for a solvent that serves as a polymerization medium, there is a problem that a heterogeneous polymer is formed, or the formed polymer exhibits insolubility to the solvent, thereby making storage difficult.

Therefore, a material that can solve such problems is required.

[Disclosure]

[Technical Problem]

The present application relates to a polymer, a cross-linkable composition comprising the same, a method for producing the cross-linkable composition, and a use of the polymer or cross-linkable composition. The present application is intended to provide a polymer capable of forming a material having an excellent antistatic function, a cross-linkable composition, a method for producing the same, and a use thereof. The present application is intended to provide a polymer which can exhibit an antistatic function without adding a separate antistatic agent, does not bleed the ingredient that exerts the antistatic function, is easy to store, and can be applied to a pressure-sensitive adhesive or the like and then stably maintain the performance of the relevant pressure-sensitive adhesive, a cross-linkable composition, a method for producing the same, and a use thereof.

[Technical Solution]

Among the physical properties mentioned in this specification, the physical property where the temperature affects the physical property is a physical property measured at room temperature, unless otherwise specified.

In this specification, the term room temperature is a natural temperature without warming or cooling, which means, for example, any one temperature in a range of about 10°C to 30°C, for example, a temperature of about 15°C, about 18°C, about 20°C, about 23°C, or about 25°C or so. In addition, unless otherwise specified in this specification, the

unit of temperature is °C.

Among the physical properties mentioned in this specification, in a case where the pressure affects the results, the relevant physical property is a physical property measured at normal pressure, unless otherwise specified. The term normal pressure is a natural pressure without pressurization or depressurization, where usually about 1 atmosphere (about 700 to 800 mmHg or so) or so is referred to as the normal pressure.

Among the physical properties mentioned in this specification, in a case where the humidity affects the results, the relevant physical property is a physical property measured at humidity without particularly being adjusted in the room temperature and normal pressure state, unless otherwise specified.

The present application relates to a polymer. As is well known, the term polymer may mean a material that two or more units (monomers, or oligomers, etc.) are linked by covalent bonds and formed. In one example, the polymer may mean a material containing a structure in which two or more units are linked by covalent bonds, and having a molecular weight of a certain level or higher.

The polymer may be an acrylic polymer. The term acrylic polymer means a polymer containing a polymerization unit of acrylic monomers as a main component.

Here, the polymerization unit means a unit formed by including the monomers in the polymer in a state where they form covalent bonds through polymerization.

In this specification, the acrylic monomer means (meth)acrylic acid or a derivative thereof (for example, alkyl acrylic acid ester or alkyl methacrylic acid ester, etc.).

In this specification, the term (meth)acrylic may mean acrylic or methacrylic, or may mean both.

Here, the matter that the polymer contains polymerization units of the acrylic monomer as a main component means a case where the ratio of the polymerization units of the acrylic monomer is 100 wt% or less, while being 50 wt% or more, 55 wt% or more, 60 wt% or more, 65 wt% or more, 70 wt% or more, 75 wt% or more, 80 wt% or more, 85 wt% or more, 90 wt% or more, 95 wt% or more, based on the total weight of all polymerization units present in the polymer.

In one example, the polymer may be an ionic polymer containing an ionic moiety.

In one example, the polymer may contain an alkyl (meth)acrylate unit. The unit is a polymerization unit formed by polymerizing the alkyl (meth)acrylate.

In the present application, as the alkyl (meth)acrylate, for example, an alkyl (meth)acrylate in which the carbon number of the alkyl group moiety is in a range of 1 to 20, 1 to 16, 1 to 12, 4 to 12, or 4 to 8 may be used. The alkyl group of the alkyl (meth)acrylate may be linear, branched, or cyclic.

A specific example of the alkyl (meth)acrylate includes methyl (meth)acrylate, ethyl (meth)acrylate, n-propyl (meth)acrylate, isopropyl (meth)acrylate, n-butyl (meth)acrylate, t-butyl (meth)acrylate, sec-butyl (meth)acrylate, pentyl (meth)acrylate, 2-ethylhexyl (meth)acrylate, 2-ethylbutyl (meth)acrylate, isononyl (meth)acrylate, n-octyl (meth)acrylate, or isooctyl (meth)acrylate, and the like, but is not limited thereto.

The weight ratio of the alkyl (meth)acrylate unit relative to the weight of all polymerization units included in the polymer may be adjusted. The weight ratio may be 30 wt% or more, 31 wt% or more, 33 wt% or more, 34 wt% or more, 35 wt% or more, 36 wt% or more, 37 wt% or more, 38 wt% or more, 39 wt% or more, 40 wt% or more, 41 wt% or more, 42 wt% or more, 43 wt% or more, 44 wt% or more, 45 wt% or more, 46 wt% or more, 47 wt% or more, 48 wt% or more, 49 wt% or more, 50 wt% or more, 51 wt% or more, 52 wt% or more, 53 wt% or more, 54 wt% or more, 55 wt% or more, 56 wt% or more, 57 wt% or more, or 58 wt% or more, and may be 80 wt% or less, 79 wt% or less, 78 wt% or less, 77 wt% or less, 76 wt% or less, 75 wt% or less, 74 wt% or less, 73 wt% or less, 72 wt% or less, 71 wt% or less, 70 wt% or less, 69 wt% or less, 68 wt% or less, 67 wt% or less, 66 wt% or less, 65 wt% or less, 64 wt% or less, 63 wt% or less, 62 wt% or less, 61 wt% or less, 60 wt% or less, or 59 wt% or less or so. The weight ratio may be within a range of any one of the above-described lower limits and any one of the above-described upper limits.

The polymer may contain a unit of Formula 1 below in addition to the alkyl (meth)acrylate unit.

[Formula 1]

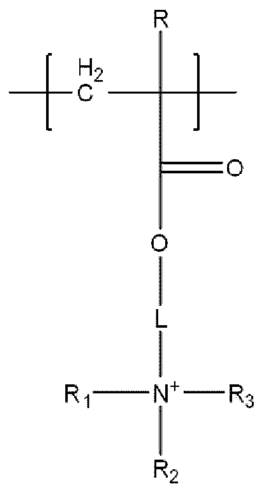

In Formula 1, L may be an alkylene group or an alkylidene group, R may be a hydrogen atom or an alkyl group, and $R_1$ to $R_3$ may each independently be an alkyl group.

In this specification, the term alkylene group means a divalent radical formed by removing one hydrogen atom from each of two different carbon atoms of an alkane. The carbon number of the alkylene group may be 2 to 20, 2 to 16, 2 to 12, 2 to 8, or 2 to 4. The alkylene group may be linear, branched, or cyclic. The alkylene group may be optionally substituted with one or more substituents.

In this specification, the term alkylidene group means a divalent radical formed by removing two hydrogen atoms from one carbon atom of an alkane. The carbon number of the alkylidene group may be 1 to 20, 1 to 16, 1 to 12, 1 to 8, or 1 to 4. The alkylidene group may be linear, branched, or cyclic. The alkylidene group may be optionally substituted with one or more substituents.

The alkylidene group or alkylene group of Formula 1 may be the alkylidene group or alkylene group.

In Formula 1, the alkyl group of R may be an alkyl group with 1 to 20 carbon atoms, 1 to 16 carbon atoms, 1 to 12 carbon atoms, 1 to 8 carbon atoms, or 1 to 4 carbon atoms, or may be a methyl group. The alkyl group may be linear, branched, or cyclic. The alkyl group may be optionally substituted with one or more substituents.

In Formula 1, $R_1$ to $R_3$ may each independently be an alkyl group with 1 to 20 carbon atoms, 1 to 16 carbon atoms, 1 to 12 carbon atoms, 1 to 8 carbon atoms, or 1 to 4 carbon atoms, or may be a methyl group or an ethyl group. The alkyl group may be linear, branched, or cyclic. The alkyl group may be optionally substituted with one or more substituents.

In one example, one of $R_1$ to $R_3$ in Formula 1 may be an ethyl group, and the other two may be methyl groups, or all $R_1$ to $R_3$ may be ethyl groups.

Through the introduction of such a structure, the polymer can exhibit physical properties suitable for forming a pressure-sensitive adhesive, while securing the desired antistatic function.

The polymer of the present application may contain the unit of Formula 1 in an amount of 20 parts by weight or more, 25 parts by weight or more, 30 parts by weight or more, 35 parts by weight or more, 40 parts by weight or more, 45 parts by weight or more, 50 parts by weight or more, 55 parts by weight or more, or 60 parts by weight or more, relative to 100 parts by weight of the alkyl (meth)acrylate unit. The polymer of the present application may contain the unit of Formula 1 in an amount of 120 parts by weight or less, 115 parts by weight or less, 110 parts by weight or less, 105 parts by weight or less, 100 parts by weight or less, 95 parts by weight or less, 90 parts by weight or less, 85 parts by weight or less, 80 parts by weight or less, 75 parts by weight or less, 70 parts by weight or less, 65 parts by weight or less, or 60 parts by weight or less, relative to 100 parts by weight of the alkyl (meth)acrylate unit. The ratio of the unit of Formula 1 may also be within a range of any one of the above-described lower limits and any of the above-described upper limits. Within this range, it is possible to provide a polymer exhibiting an appropriate antistatic function and being suitable for forming a pressure-sensitive adhesive. The pressure-sensitive adhesive formed from such a polymer can exhibit appropriate adhesion and antistatic functions, cannot cause contamination by static electricity or contamination of the adherend upon peeling, and can also stably secure reworkability.

The polymer may also contain other required polymerization units in addition to the above polymerization units.

For example, the polymer may contain a unit of Formula 2below.

[Formula 2]

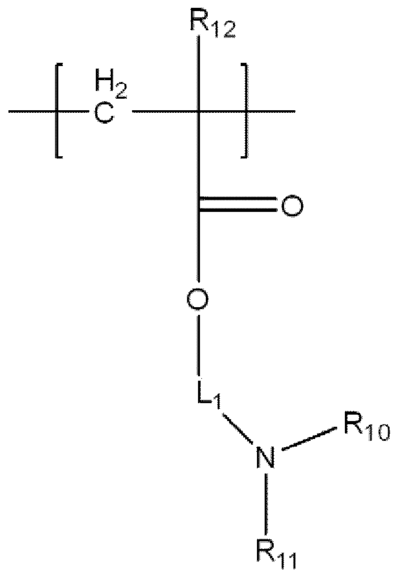

In Formula 2, $L_1$ may be an alkylene group or an alkylidene group, $R_{12}$ may be a hydrogen atom or an alkyl group, and $R_{10}$ and $R_{11}$ may each independently be an alkyl group.

In Formula 2, the alkylene group may be an alkylene group with 2 to 20, 2 to 16, 2 to 12, 2 to 8, or 2 to 4 carbon atoms. The alkylene group may be linear, branched, or cyclic. The alkylene group may be optionally substituted with one or more substituents.

In Formula 2, the alkylidene group may be an alkylidene group with 1 to 20, 1 to 16, 1 to 12, 1 to 8, or 1 to 4. The alkylidene group may be linear, branched, or cyclic. The alkylidene group may be optionally substituted with one or more substituents.

In Formula 2, the alkyl group of $R_{12}$ may be an alkyl group with 1 to 20 carbon atoms, 1 to 16 carbon atoms, 1 to 12 carbon atoms, 1 to 8 carbon atoms, or 1 to 4 carbon atoms, or may be a methyl group. The alkyl group may be linear, branched, or cyclic. The alkyl group may be optionally substituted with one or more substituents.

In Formula 2, $R_{10}$ and $R_{11}$ may each independently be an alkyl group with 1 to 20 carbon atoms, 1 to 16 carbon atoms, 1 to 12 carbon atoms, 1 to 8 carbon atoms, or 1 to 4 carbon atoms, or may be a methyl group or an ethyl group. The alkyl group may be linear, branched, or cyclic. The alkyl group may be optionally substituted with one or more substituents.

The unit of Formula 2 may be a unit acting as a precursor for the unit of Formula 1 in the process of manufacturing the polymer to be described below, and may be a unit that remains without being converted to Formula 1 during the conversion process.

The polymer of the present application may contain the unit of Formula 2 above in an amount of 0.1 parts by weight or more, 0.5 parts by weight or more, 1 part by weight or more, 2 parts by weight or more, 3 parts by weight or more, 4 parts by weight or more, 5 parts by weight or more, 5.5 parts by weight or more, 6 parts by weight or more, 7 parts by weight or more, 8 parts by weight or more, 9 parts by weight or more, 10 parts by weight or more, 11 parts by weight or more, 12 parts by weight or more, 13 parts by weight or more, or 14 parts by weight or more, relative to 100 parts by weight of the alkyl (meth)acrylate unit. The polymer of the present application may contain the unit of Formula 2 above in an amount of 30 parts by weight or less, 28 parts by weight or less, 26 parts by weight or less, 24 parts by weight or less, 22 parts by weight or less, 20 parts by weight or less, 18 parts by weight or less, 16 parts by weight or less, 14 parts by weight or less, 12 parts by weight or less, or 11 parts by weight or less, relative to 100 parts by weight of the alkyl (meth)acrylate unit. The ratio of the unit of Formula 2 may also be within a range of any one of the above-described lower limits and any of the above-described upper limits. Within this range, it is possible to provide a polymer exhibiting an appropriate antistatic function and being suitable for forming a pressure-sensitive adhesive. The pressure-sensitive adhesive formed from such a polymer can exhibit appropriate adhesion and antistatic functions, cannot cause contamination by static electricity or contamination of the adherend upon peeling, and can also stably secure reworkability.

When the unit of Formula 2 is included, the ratio (A/B) of the weight (A) of the unit of Formula 1 above to the weight (B) of the unit of Formula 2 above may be 0.5 or more, 1 or more, 1.5 or more, 2 or more, 2.5 or more, 3 or more, 3.5 or more, 4 or more, 4.5 or more, 5 or more, or 5.5 or more. In another example, the ratio may also be 20 or less, 19 or less, 18 or less, 17 or less, 16 or less, 15 or less, 14 or less, 13 or less, 12 or less, 11 or less, 10 or less, 9 or less, 8 or less, 7 or less, 6 or less, 5 or less, or 4 or less or so. The weight ratio A/B may also be within a range of any one of the above-described upper limits and any one of the above-described lower limits.

The polymer may also optionally contain additional polymerization units in addition to the above units.

The molecular weight of the polymer can be adjusted within an appropriate range. For example, the molecular

weight of the polymer is a weight average molecular weight (Mw), which may be approximately 5,000 g/mol or more, 10,000 g/mol or more, 15,000 g/mol or more, 20,000 g/mol or more, 25,000 g/mol or more, 30,000 g/mol or more, 35,000 g/mol or more, 40,000 g/mol or more, 45,000 g/mol or more, 50,000 g/mol or more, 55,000 g/mol or more, or 60,000 g/mol or more. The weight average molecular weight may be about 200,000 g/mol or less, 150,000 g/mol or less, 100,000 g/mol or less, 90,000 g/mol or less, 80,000 g/mol or less, 70,000 g/mol or less, 60,000 g/mol or less, or 50,000 g/mol or less or so. The molecular weight of the polymer may be within a range of any one of the above-described lower limits and any one of the above-described upper limits.

For example, the molecular weight of the polymer is a number average molecular weight (Mn), which may be approximately 5,000 g/mol or more, 10,000 g/mol or more, 15,000 g/mol or more, 20,000 g/mol or more, or 25,000 g/mol or more. The number average molecular weight may be about 200,000 g/mol or less, 150,000 g/mol or less, 100,000 g/mol or less, 90,000 g/mol or less, 80,000 g/mol or less, 70,000 g/mol or less, 60,000 g/mol or less, 50,000 g/mol or less, 45,000 g/mol or less, 40,000 g/mol or less, 35,000 g/mol or less, 30,000 g/mol or less, or 25,000 g/mol or less or so. The molecular weight of the polymer may be within a range of any one of the above-described lower limits and any one of the above-described upper limits.

The weight average molecular weight and the number average molecular weight are values measured by GPC (Gel Permeation Chromatograph) using polystyrene as a calibration standard sample, and the specific measurement method is described in Examples.

The polymer may have a molecular weight distribution, that is, a ratio (Mw/Mn) of the weight average molecular weight (Mw) and the number average molecular weight (Mn) of 1 or more, 1.5 or more, or 2 or more. In another example, the ratio Mw/Mn may also be 10 or less, 9 or less, 8 or less, 7 or less, 6 or less, 5 or less, 4 or less, 3 or less, or 2 or less or so. The molecular weight distribution of the polymer may be within a range of any one of the above-described lower limits and any one of the above-described upper limits.

The present application also relates to a cross-linkable composition. The cross-linkable composition means a composition that can be cross-linked. The cross-linkable composition can be cross-linked to form a pressure-sensitive adhesive. In this case, the meaning of pressure-sensitive adhesive is as known in the industry.

The cross-linkable composition may comprise a cross-linkable polymer and an ionic polymer. In this case, the ionic polymer may include the above-described polymer.

Meanwhile, here, the cross-linkable polymer is a polymer that can participate in a cross-linking reaction by having a cross-linkable functional group (polar functional group) as described below.

The cross-linkable polymer is also a material that two or more units (monomers, or oligomers, etc.) are linked by covalent bonds and formed.

The cross-linkable polymer may be an acrylic polymer. The meaning of the term acrylic polymer is as described above.

Therefore, the cross-linkable polymer may also contain polymerization units of the acrylic monomer in a ratio of 100 wt% or less, while being 50 wt% or more, 55 wt% or more, 60 wt% or more, 65 wt% or more, 70 wt% or more, 75 wt% or more, 80 wt% or more, 85 wt% or more, 90 wt% or more, or 95 wt% or more, based on the total weight of all polymerization units present in the polymer.

In one example, the polymer may contain an alkyl (meth)acrylate unit. The unit is a polymerization unit formed by polymerizing the alkyl (meth)acrylate.

At this time, the types of the applicable alkyl (meth)acrylates are the same as described in the ionic polymer above. Therefore, as the alkyl (meth)acrylate, for example, an alkyl (meth)acrylate in which the carbon number of the alkyl group moiety is in a range of 1 to 20, 1 to 16, 1 to 12, 4 to 12, or 4 to 8 may be used. The alkyl group of the alkyl (meth)acrylate may be linear, branched, or cyclic.

In one example, the polymer may contain, as the alkyl (meth)acrylate units, an alkyl (meth)acrylate unit (first unit) having an alkyl group with 1 to 3 carbon atoms and an alkyl (meth)acrylate unit (second unit) having an alkyl group with 4 or more carbon atoms. Through this, it is possible to obtain a polymer efficiently securing the desired function (antistatic function, etc.) while properties such as a glass transition temperature are adjusted to an appropriate level, and having properties suitable for application as a pressure-sensitive adhesive.

In one example, the alkyl (meth)acrylate unit having an alkyl group with 1 to 3 carbon atoms, which is the first unit, may be an alkyl methacrylate unit having an alkyl group with 1 to 3 carbon atoms.

The carbon number of the alkyl group included in the alkyl (meth)acrylate unit, which is the second unit, may be 4 to 20, 4 to 16, 4 to 12, 4 to 8, or 6 to 8. Additionally, the second unit may be an alkyl acrylate unit.

The weight ratio of the alkyl (meth)acrylate unit relative to the weight of all polymerization units included in the cross-linkable polymer may be adjusted. The weight ratio may be 60 wt% or more, 61 wt% or more, 63 wt% or more, 64 wt% or more, 65 wt% or more, 66 wt% or more, 67 wt% or more, 68 wt% or more, 69 wt% or more, 70 wt% or more, 71 wt% or more, 72 wt% or more, 73 wt% or more, 74 wt% or more, 75 wt% or more, 76 wt% or more, 77 wt% or more, 78 wt% or more, 79 wt% or more, 80 wt% or more, 81 wt% or more, 82 wt% or more, 83 wt% or more, 84 wt% or more, or 85 wt% or more, and may be 95 wt% or less, 94 wt% or less, 93 wt% or less, 92 wt% or less, 91 wt% or less, 90 wt% or less, 89 wt% or less, 88

wt% or less, 87 wt% or less, or 86 wt% or less or so. The weight ratio may be within a range of any one of the above-described lower limits and any one of the above-described upper limits.

The ratio (A2/A1) of the second unit weight (A2) to the first unit weight (A1) in the polymer may be adjusted. The ratio (A2/A1) may be 2 or more, 3 or more, 4 or more, 5 or more, 6 or more, or 7 or more. The ratio (A2/A1) may be 20 or less, 19 or less, 18 or less, 17 or less, 16 or less, 15 or less, 14 or less, 13 or less, 12 or less, 11 or less, 10 or less, 9 or less, or 8 or less or so. The ratio (A2/A1) may be within a range of any one of the above-described lower limits and any one of the above-described upper limits. Through this, it is possible to obtain a polymer efficiently securing the desired function (antistatic function, etc.) while properties such as a glass transition temperature are adjusted to an appropriate level, and having properties suitable for application as a pressure-sensitive adhesive.

The polymer may also contain other required polymerization units in addition to the above polymerization units.

For example, the polymer may contain a unit of Formula 3below.

[Formula 3]

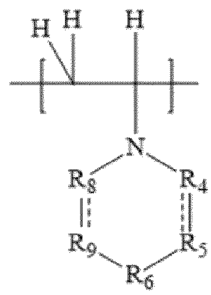

In Formula 3, $R_4$, $R_5$, $R_8$ and $R_9$ may each independently be a carbon atom or a carbonyl group, $R_6$ may be a carbon atom or an oxygen atom or may not be present, and the bond between $R_4$ and $R_5$ and the bond between $R_8$ and $R_9$ may each independently be a single bond or a double bond.

In Formula 3, the absence of $R_6$ means that $R_5$ and $R_9$ are directly linked.

In Formula 3, when $R_4$, $R_5$, $R_6$, $R_8$, and $R_9$ are carbon atoms, hydrogen atoms may be bonded to the relevant carbon atom to match the valency considering the overall structure of the compound of Formula 3.

In one example, in Formula 3, $R_4$, $R_5$, $R_8$ and $R_9$ may each independently be a carbon atom or a carbonyl group, $R_6$ may be a carbon atom, or may not be present, and the bond between $R_4$ and $R_5$ and the bond between $R_8$ and $R_9$ may each independently be a single bond, or a double bond, but at least one of $R_4$, $R_5$, $R_8$, and $R_9$ may be a carbonyl group.

In one example, in Formula 3, any one of $R_4$ and $R_8$ may be a carbon atom, the other may be a carbonyl group, $R_6$ may not be present, and the bond between $R_4$ and $R_5$ and the bond between $R_8$ and $R_9$ may be single bonds.

In one example, in Formula 3, $R_4$, $R_5$, $R_8$, and $R_9$ may each be a carbon atom, $R_6$ may not be present, and the bond between $R_4$ and $R_5$ and the bond between $R_8$ and $R_9$ may each be a double bond.

In one example, in Formula 3, $R_4$, $R_5$, $R_8$, and $R_9$ may each be a carbon atom, $R_6$ may not be present, and the bond between $R_4$ and $R_5$ and the bond between $R_8$ and $R_9$ may each be a single bond.

In one example, in Formula 3, $R_4$, $R_5$, $R_6$, $R_8$, and $R_9$ may each be a carbon atom, and the bond between $R_4$ and $R_5$ and the bond between $R_8$ and $R_9$ may each be a single bond.

In one example, in Formula 3, $R_4$, $R_5$, $R_8$, and $R_9$ may each be a carbon atom, $R_6$ may be an oxygen atom, and the bond between $R_4$ and $R_5$ and the bond between $R_8$ and $R_9$ may each be a single bond.

When the unit of Formula 3 above is present, the ratio of the relevant unit in the cross-linkable polymer may be, for example, 0.5 parts by weight or more, 1 part by weight or more, 2 parts by weight or more, 3 parts by weight or more, 4 parts by weight or more, 5 parts by weight or more, or 6 parts by weight or more, relative to 100 parts by weight of the alkyl (meth) acrylate unit. When the unit of Formula 3 above is present, the ratio of the relevant unit may be, for example, 20 parts by weight or less, 19 parts by weight or less, 18 parts by weight or less, 17 parts by weight or less, 16 parts by weight or less, 15 parts by weight or less, 14 parts by weight or less, 13 parts by weight or less, 12 parts by weight or less, 11 parts by weight or less, 10 parts by weight or less, 9 parts by weight or less, 8 parts by weight or less, or 7 parts by weight or less, relative to 100 parts by weight of the alkyl (meth)acrylate unit. When the unit of Formula 3 is present, the ratio may be within a range of any one of the above-described lower limits and any one of the above-described upper limits. This range is advantageous for forming a pressure-sensitive adhesive that exhibits an appropriate antistatic function, does not cause contamination by static electricity, or contamination by peeling, and exhibits appropriate adhesion and reworkability.

The cross-linkable polymer may further contain a polar group-containing unit, if necessary. Such a unit may be necessary to control the cohesion force or to implement a cross-linked structure. The polar group-containing unit means a polymerization unit formed by a monomer having a polar group. The polar group-containing unit may be a hydroxy group-containing unit or a carboxyl group-containing unit, and the like. It is particularly advantageous to apply the hydroxy group-containing unit, but is not limited thereto. Since the carboxyl group-containing unit may also cause corrosion in electronic devices or optical devices, and the like, it may not be present in the polymer depending on the use of the polymer.

The hydroxyl group-containing monomer capable of forming the hydroxyl group-containing unit may include 2-hydroxyethyl (meth)acrylate, 2-hydroxypropyl (meth)acrylate, 4-hydroxybutyl (meth)acrylate, 6-hydroxyhexyl (meth) acrylate, 8-hydroxyoctyl (meth)acrylate, 2-hydroxy polyethylene glycol (meth)acrylate, or 2-hydroxy polypropylene glycol (meth)acrylate, and the like, and usually, a hydroxyalkyl (meth)acrylate may be used. In the hydroxyalkyl (meth)acrylate, the number of carbon atoms of the alkyl group may be 1 to 20, 1 to 16, 1 to 12, 1 to 8, 2 to 8, 3 to 8, 4 to 8, or 4 to 6 or so.

An example of the carboxyl group-containing monomer capable of forming the carboxyl group-containing unit may include (meth)acrylic acid, 2-(meth)acryloyloxy acetic acid, 3-(meth)acryloyloxy propylic acid, 4-(meth)acryloyloxy butyric acid, an acrylic acid dimer, itaconic acid, maleic acid and/or maleic anhydride, and the like.

The polar group-containing unit may be included in the polymer in a ratio of 1 part by weight or more, 2 parts by weight or more, 3 parts by weight or more, 4 parts by weight or more, 5 parts by weight or more, 6 parts by weight or more, 7 parts by weight or more, 8 parts by weight or more, 9 parts by weight or more, 10 parts by weight or more, 11 parts by weight or more, 12 parts by weight or more, or 13 parts by weight or more, relative to 100 parts by weight of the alkyl (meth)acrylate unit. The polar group-containing unit may be included in the cross-linkable polymer in an amount of 30 parts by weight or less, 29 parts by weight or less, 28 parts by weight or less, 27 parts by weight or less, 26 parts by weight or less, 25 parts by weight or less, 24 parts by weight or less, 23 parts by weight or less, 22 parts by weight or less, 21 parts by weight or less, 20 parts by weight or less, 19 parts by weight or less, 18 parts by weight or less, 17 parts by weight or less, 16 parts by weight or less, 15 parts by weight or less, 14 parts by weight or less, or 13.5 parts by weight or less, relative to 100 parts by weight of the alkyl (meth)acrylate unit. When the polar group-containing unit is present, the ratio may be within a range of any one of the above-described lower limits and any one of the above-described upper limits. This range can be effective in forming a pressure-sensitive adhesive that does not leave contamination by static electricity or contamination on the adherend during the peeling process, while exhibiting an appropriate antistatic function, and has appropriate reworkability and adhesion.

The cross-linkable polymer may also contain other polymerization units if desired.

The molecular weight of the cross-linkable polymer can be adjusted within an appropriate range. For example, the molecular weight of the cross-linkable polymer is a weight average molecular weight (Mw), which may be approximately 10,000 g/mol or more, 50,000 g/mol or more, 100,000 g/mol or more, 150,000 g/mol or more, 200,000 g/mol or more, 250,000 g/mol or more, 300,000 g/mol or more, 350,000 g/mol or more, 400,000 g/mol or more, 450,000 g/mol or more, 500,000 g/mol or more, 550,000 g/mol or more, or 600,000 g/mol or more. The weight average molecular weight may be about 2,000,000 g/mol or less, 1,500,000 g/mol or less, 1,000,000 g/mol or less, 900,000 g/mol or less, 800,000 g/mol or less, 700,000 g/mol or less, or 650,000 g/mol or less or so. The molecular weight of the polymer may be within a range of any one of the above-described lower limits and any one of the above-described upper limits.

For example, the molecular weight of the polymer is a number average molecular weight (Mn), which may be approximately 5,000 g/mol or more, 10,000 g/mol or more, 15,000 g/mol or more, 20,000 g/mol or more, 25,000 g/mol or more, 30,000 g/mol or more, 35,000 g/mol or more, 40,000 g/mol or more, 45,000 g/mol or more, 50,000 g/mol or more, 55,000 g/mol or more, 60,000 g/mol or more, 65,000 g/mol or more, 70,000 g/mol or more, 75,000 g/mol or more, 80,000 g/mol or more, 85,000 g/mol or more, 90,000 g/mol or more, 95,000 g/mol or more, or 100,000 g/mol or more. The number average molecular weight may be about 200,000 g/mol or less, 150,000 g/mol or less, or 100,000 g/mol or less or so. The molecular weight of the polymer may be within a range of any one of the above-described lower limits and any one of the above-described upper limits.

The weight average molecular weight and number average molecular weight can be obtained in the same manner as in the ionic polymer.

The polymer may have a molecular weight distribution, that is, a ratio (Mw/Mn) of the weight average molecular weight (Mw) and the number average molecular weight (Mn) of 1 or more, 1.5 or more, 2 or more, 2.5 or more, 3 or more, 3.5 or more, 4 or more, 4.5 or more, 5 or more, 5.5 or more, or 6 or more. In another example, the ratio Mw/Mn may also be 10 or less, 9.5 or less, 9 or less, 8.5 or less, 8 or less, 7.5 or less, 7 or less, 6.5 or less, or 6 or less or so. The molecular weight distribution of the cross-linkable polymer may be within a range of any one of the above-described lower limits and any one of the above-described upper limits.

The cross-linkable composition comprises such a cross-linkable polymer together with the above-described ionic polymer.

The ratio of the cross-linkable polymer in the cross-linkable composition is not particularly limited, but may be about 50 wt% or more, 55 wt% or more, 60 wt% or more, 65 wt% or more, 70 wt% or more, 75 wt% or more, 80 wt% or more, 85 wt% or more, 90 wt% or more or so. In another example, the ratio may be less than 100 wt%, 95 wt% or less, 90 wt% or less, 85 wt% or less, 80 wt% or less, 75 wt% or less, or 70 wt% or less or so. The ratio may be within a range of any one of the above-described lower limits and any one of the above-described upper limits.

The ionic polymer may be included in a ratio of 1 part by weight or more, 2.5 parts by weight or more, 5 parts by

weight or more, 10 parts by weight or more, 15 parts by weight or more, 20 parts by weight or more, 25 parts by weight or more, 30 parts by weight or more, 35 parts by weight or more, or 40 parts by weight or more or so, relative to 100 parts by weight of the cross-linkable polymer. The ionic polymer may also be included in a ratio of 60 parts by weight or less, 55 parts by weight or less, 50 parts by weight or less, 45 parts by weight or less, 40 parts by weight or less, 35 parts by weight or less, 30 parts by weight or less, 25 parts by weight or less, 20 parts by weight or less, 15 parts by weight or less, 10 parts by weight or less, or 7.5 parts by weight or less, relative to 100 parts by weight of the cross-linkable polymer. The ratio may be within a range of any one of the above-described lower limits and any one of the above-described upper limits. Under such a ratio, it is possible to appropriately form a cross-linkable composition with desired properties.

The cross-linkable composition may comprise a variety of other necessary additives if it comprises the cross-linkable and ionic polymers.

For example, the cross-linkable composition may further comprise a cross-linking agent, if necessary. When the cross-linking agent is included, at least the cross-linkable polymer may exist in a cross-linked state in the cross-linkable composition. That is, the cross-linking agent may implement a cross-linked structure with the cross-linkable polymer containing the polar group-containing unit.

As the cross-linking agent, an appropriate type may be selected depending on the type of polar group contained in the cross-linkable polymer. For example, when the polar group is a hydroxy group, an isocyanate cross-linking agent may be typically used as the cross-linking agent. However, the type of applicable cross-linking agent is not limited to the above, and other cross-linking agents may also be used appropriately.

As the isocyanate cross-linking agent, an aliphatic cyclic polyvalent isocyanate compound and/or an aliphatic acyclic polyvalent isocyanate compound may be used. Here, the polyvalent means that the compound contains two or more isocyanate groups. The number of isocyanate groups present in the compound may be 2 to 10, 2 to 9, 2 to 8, 2 to 7, 2 to 6, 2 to 5, 2 to 4, or 2 or 3. The aliphatic cyclic isocyanate compound may be exemplified by an isocyanate compound such as isophorone diisocyanate, methylene dicyclohexyl diisocyanate, or cyclohexane diisocyanate, or a derivative such as a dimer or trimer thereof, or a reactant of any one of the foregoing with a polyol (e.g., trimethylolpropane), and the aliphatic acyclic isocyanate compound may be exemplified by an alkylene diisocyanate compound with 1 to 20 carbon atoms, 1 to 16 carbon atoms, 1 to 12 carbon atoms, or 1 to 8 carbon atoms, such as hexamethylene diisocyanate, or a derivative such as a dimer or trimer thereof, or a reactant of any one of the foregoing with a polyol (e.g., trimethylolpropane), without being limited thereto.

The usage ratio of the cross-linking agent may be 0.01 parts by weight or more, 0.05 parts by weight or more, 0.1 parts by weight or more, 0.15 parts by weight or more, 0.2 parts by weight or more, or 0.25 parts by weight or more, relative to 100 parts by weight of the total cross-linkable and ionic polymers (based on solid content). In another example, the ratio may be 10 parts by weight or less, 9 parts by weight or less, 8 parts by weight or less, 7 parts by weight or less, 6 parts by weight or less, 5 parts by weight or less, 4 parts by weight or less, 3 parts by weight or less, 2 parts by weight or less, 1 part by weight or less, 0.9 parts by weight or less, 0.8 parts by weight or less, 0.7 parts by weight or less, 0.6 parts by weight or less, 0.5 parts by weight or less, 0.4 parts by weight or less, or 0.3 parts by weight or less or so. The ratio of the cross-linking agent may be within a range of any one of the above-described upper limits and any one of the above-described lower limits.

In such a range, the cross-linking agent can efficiently form the desired cross-linked structure.

In consideration of efficient formation of the desired cross-linked structure and stability before cross-linking, and the like, the cross-linkable composition may further comprise a cross-linking retardant.

As the cross-linking retardant, a known compound may be used, and for example, one or two or more selected from a β-ketoester such as methyl acetoacetate, ethyl acetoacetate, octyl acetoacetate, oleyl acetoacetate, lauryl acetoacetate and/or stearyl acetoacetate, or a β-diketones such as acetylacetone, 2,4-hexanedione, and/or benzoylacetone may be used.

The usage ratio of the cross-linking retardant may be 0.1 parts by weight or more, 0.5 parts by weight or more, 1 part by weight or more, 1.5 parts by weight or more, 2 parts by weight or more, 2.5 parts by weight or more, or 3 parts by weight or more, relative to 100 parts by weight of the total cross-linkable and ionic polymers (based on solid content). In another example, the ratio may be 10 parts by weight or less, 9 parts by weight or less, 8 parts by weight or less, 7 parts by weight or less, 6 parts by weight or less, 5 parts by weight or less, 4 parts by weight or less, or 3 parts by weight or less or so. The ratio of the cross-linking retardant may be within a range of any one of the above-described upper limits and any one of the above-described lower limits.

To implement an appropriate cross-linked structure, the ratio (A/B) of the weight (A) of the cross-linking retardant to the weight (B) of the cross-linking agent may be 0.5 or more, 1 or more, 2 or more, 3 or more, 4 or more, 5 or more, 6 or more, 7 or more, 8 or more, 9 or more, 10 or more, 11 or more, or 12 or more or so. The weight ratio (A/B) may also be 30 or less, 28 or less, 26 or less, 24 or less, 22 or less, 20 or less, 18 or less, 16 or less, 14 or less, or 12 or less or so. The weight ratio A/B may also be within a range of any one of the above-described upper limits and any one of the above-described lower limits.

The cross-linkable composition may also comprise appropriate additional components in addition to the above components, and for example, may also further comprise a silane coupling agent, a tackifier, a multifunctional acrylate, an

antifoaming agent, an antioxidant, a surfactant and/or a plasticizer, and the like.

The present application also relates to a method of preparing the cross-linkable composition.

The preparation method may basically comprise a step of mixing the cross-linkable polymer and the ionic polymer.

The respective polymers can be formed by polymerizing monomers included in a monomer mixture formulated in consideration of the desired composition of polymerization units.

The polymerization method is not limited, but for example, solution polymerization may be applied.

When the solution polymerization is applied, it may be appropriate to perform at least a two-step reaction for obtaining the ionic polymer.

For example, the method of obtaining an ionic polymer containing the unit of Formula 1 above may comprise steps of reacting a monomer mixture including an alkyl (meth)acrylate and a compound of Formula 4 below to obtain a polymer, and reacting the polymer with a haloalkane.

To introduce the unit of Formula 1 into a polymer, it is possible to consider a method of directly introducing an ionic monomer containing the structure of Formula 1 into the monomer mixture for solution polymerization and performing polymerization. However, as a confirmatory result, such an ionic monomer generally has poor solubility in the solvent in which the solution polymerization is performed, and accordingly, a heterogeneous polymer is formed, or the solubility of the formed polymer in the solvent is lowered, thereby causing a storage problem. In addition, the ionic polymer formed in this way has poor formulation properties with the cross-linkable polymer.

However, the above problem can be solved by producing a polymer through the above two-step reaction applying the compound of Formula 4 below.

The compound of Formula 4 below may be polymerized to form the unit of Formula 2 above, and this unit may be converted to the unit of Formula 1 above through the reaction with the haloalkane. By adjusting the reaction in this process, some of the units of Formula 2 above may be converted to the units of Formula 1, and other units may also remain.

[Formula 4]

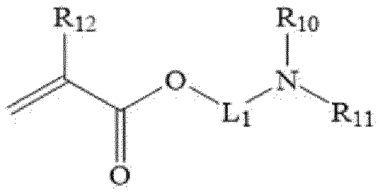

In Formula 4, $L_1$ may be an alkylene group or an alkylidene group, $R_{12}$ may be a hydrogen atom or an alkyl group, and $R_{10}$ and $R_{11}$ may each independently be an alkyl group.

An example of the compound of Formula 4 above includes dialkylaminoalkyl (meth)acrylate, and the like.

In Formula 4, the alkylene group may be an alkylene group with 2 to 20, 2 to 16, 2 to 12, 2 to 8, or 2 to 4 carbon atoms. The alkylene group may be linear, branched, or cyclic. The alkylene group may be optionally substituted with one or more substituents.

In Formula 4, the alkylidene group may be an alkylidene group with 1 to 20, 1 to 16, 1 to 12, 1 to 8, or 1 to 4. The alkylidene group may be linear, branched, or cyclic. The alkylidene group may be optionally substituted with one or more substituents.

In Formula 4, the alkyl group of $R_{12}$ may be an alkyl group with 1 to 20 carbon atoms, 1 to 16 carbon atoms, 1 to 12 carbon atoms, 1 to 8 carbon atoms, or 1 to 4 carbon atoms, or may be a methyl group. The alkyl group may be linear, branched, or cyclic. The alkyl group may be optionally substituted with one or more substituents.

In Formula 4, $R_{10}$ and $R_{11}$ may each independently be an alkyl group with 1 to 20 carbon atoms, 1 to 16 carbon atoms, 1 to 12 carbon atoms, 1 to 8 carbon atoms, or 1 to 4 carbon atoms, or may be a methyl group or an ethyl group. The alkyl group may be linear, branched, or cyclic. The alkyl group may be optionally substituted with one or more substituents.

In the method for producing the polymer, the alkyl (meth)acrylate included in the monomer mixture is a monomer that forms the alkyl (meth)acrylate unit, and the compound of Formula 4 forms the unit of Formula 2, which is a precursor for forming the unit of Formula 1 above.

Therefore, the specific type of the alkyl (meth)acrylate in the monomer mixture may be controlled to be capable of forming the alkyl (meth)acrylate unit, and the contents for the alkyl (meth)acrylate unit and the units of Formulas 1 and 2 may be applied to the ratio of the ratio of the alkyl (meth)acrylate and the compound of Formula 4.

In such a monomer mixture, a solvent may further be present. As the solvent, a solvent applicable to conventional solution polymerization may be applied, and for example, one, or two or more selected from a substituted or unsubstituted aliphatic $C_1$-$C_{20}$ saturated hydrocarbon solvent such as n-hexane, n-heptane, cyclohexane, and isooctane; an aliphatic

ketone solvent such as acetone, methyl ethyl ketone, methyl propyl ketone, methyl isopropyl ketone, methyl butyl ketone, methyl isobutyl ketone, diethyl ketone, diisopropyl ketone, cyclobutanone, cyclopentanone, and cyclohexanone; an aliphatic ester solvent such as methyl acetate, ethyl acetate (EAc), propyl acetate, isopropyl acetate, butyl acetate, and isobutyl acetate; and/or a substituted or unsubstituted aromatic solvent such as benzene, toluene, ethylbenzene, and xylene, and the like may be used, without being limited thereto.

In the polymerization process, the solvent may be included in an amount of 40 parts by weight or more, 45 parts by weight or more, or 50 parts by weight or more relative to 100 parts by weight of all monomers included in the monomer mixture. The solvent may be included in an amount of 70 parts by weight or less, 65 parts by weight or less, or 60 parts by weight or less relative to 100 parts by weight of all monomers. The ratio of the solvent may be adjusted as needed.

A reaction initiator may further be present in the monomer mixture. The type of the reaction initiator is not particularly limited, and for example, a radical initiator may be used. As the radical initiator, a radical thermal initiator or a radical photoinitiator may be used, and the specific types thereof are not particularly limited.

For example, as the initiator, for example, an azo-based initiator such as 2,2-azobis-2,4-dimethylvaleronitrile (V-65, manufactured by Wako), 2,2-azobisisobutyronitrile (V-60, manufactured by Wako) and/or 2,2-azobis-2-methylbutyronitrile (V-59, manufactured by Wako), and the like may be used, without being limited thereto.

The reaction initiator may be present in an appropriate ratio depending on the desired polymer, and may be included in a concentration of, for example, 200 ppm or more, 250 ppm or more, 300 ppm or more, or 350 ppm or more. In another example, the reaction initiator may be included in a concentration of 600 ppm or less, 550 ppm or less, 500 ppm or 450 ppm or less.

In the monomer mixture, optional additives such as a chain transfer agent may further be included.

The method of performing polymerization of such a monomer mixture is not particularly limited, and the polymerization may proceed according to a known solution polymerization method.

After forming a polymer by such a method, the relevant polymer may be reacted with a haloalkane to form the unit of Formula 1 above.

The reaction may also be performed by preparing the polymer and then adding the haloalkane into the obtained polymerization solution, and may also be performed by recovering the polymer from the polymerization solution and then mixing it again with the haloalkane.

As the haloalkane, a compound in which one of the hydrogen atoms of the alkane is replaced with halogen may be used. At this time, the substituted halogen may be exemplified by Br, Cl, F, or I, and the like, but is not limited thereto.

As the haloalkane, a haloalkane with 1 to 20 carbon atoms, 1 to 16 carbon atoms, 1 to 12 carbon atoms, 1 to 8 carbon atoms, or 1 to 4 carbon atoms may be used, and for example, halomethane or haloethane may be used. The haloalkane may be linear, branched, or cyclic, and may be optionally substituted with one or more substituents.

The reaction may be performed by mixing the haloalkane in a state of being diluted in an appropriate solvent with the polymerization solution including the polymer or another solution including the polymer.

Such a reaction may be performed, for example, at a temperature of about 50°C or more, 55°C or more, 60°C or more, 65°C or more, 70°C or more, 75°C or more, or 80°C or more. The reaction temperature may also be 200°C or less, 190°C or less, 180°C or less, 170°C or less, 160 °C or less, 150 °C or less, 140 °C or less, 130°C or less, 120°C or less, 110°C or less, 100°C or less, 95°C or less, 90°C or less, 85°C or less, or 80°C or less or so. The range of reaction temperature may also be within a range of any one of the above-described upper limits and any one of the above-described lower limits.

The reaction may be performed, for example, for about 1 hour or more, 5 hours or more, 15 hours or more, or 20 hours or more. The reaction time may also be 200 hours or less, 150 hours or less, 100 hours or less, 90 hours or less, 80 hours or less, 70 hours or less, 60 hours or less, 50 hours or less, 40 hours or less, 30 hours or less, or 20 hours or less or so. The range of reaction time may also be within a range of any one of the above-described upper limits and any of the above-described lower limits.

It is possible to obtain a polymer having the desired monomer composition uniformly and having excellent solubility to solvents and excellent formulation properties with other polymers such as cross-linkable polymers by such a method.

In the method for producing the cross-linkable composition, the cross-linkable polymer can be produced by applying a known solution polymerization method, and the like.

In addition, the method for producing a cross-linkable composition may also further comprise a step of formulating other additives such as the cross-linking retardant or cross-linking agent.

The present application also relates to a use of the polymer or cross-linkable composition. For example, the cross-linkable composition or polymer may be used in various fields that require an antistatic function.

For example, the present application may relate to a laminate to which the cross-linkable composition or its cross-linked product is applied. Here, the cross-linked product of the cross-linkable composition may be a pressure-sensitive adhesive, and in this case, the cross-linkable polymer may be a pressure-sensitive adhesive polymer.

Such a laminate may comprise, for example, an electronic substrate, and the pressure-sensitive adhesive

attached to one or both sides of the electronic substrate.

Here, the type of electronic substrate is not particularly limited, and various types requiring prevention of static charge may be applied.

In one example, the electronic substrate may be an OLED (Organic Light Emitting Diode) panel. Therefore, in this case, the laminate may be an OLED device comprising an OLED panel and the pressure-sensitive adhesive attached to one or both sides of the OLED panel.

The method of forming the cross-linked product applied to the laminate is not particularly limited. For example, the cross-linked product may be formed by applying an appropriate cross-linking method to the cross-linkable composition considering the type of the applied polymer and/or cross-linking agent. For example, if the polymer and/or cross-linking agent is a type that is cross-linked by heat application, the cross-linked product can be formed by applying appropriate heat, and other cross-linking methods can also be applied.

When the cross-linked product is in the form of a layer in the laminate, the thickness of the relevant layer is not particularly limited, where it may have an appropriate thickness. For example, it may be 10 μm or more, 30 μm or more, 50 μm or more, 70 μm or more, or 90 μm or more. In another example, the thickness of the layer may be 500 μm or less, 400 μm or less, 300 μm or less, 200 μm or less, 180 μm or less, 160 μm or less, 140 μm or less, or 120 μm or less.

[Effects of Invention]

The present application can provide a polymer, a cross-linkable composition comprising the same, a method for producing the cross-linkable composition, and a use of the polymer or the cross-linkable composition. The present application can provide a polymer capable of forming a material having an excellent antistatic function, a cross-linkable composition and a production method thereof, and a use thereof. The present application can provide a polymer which can exhibit an antistatic function without adding a separate antistatic agent, does not bleed the ingredient exerting the antistatic function, is easy to store, and can maintain performance of a pressure-sensitive adhesive after being applied to the relevant pressure-sensitive adhesive, and the like, a cross-linkable composition, a production method thereof, and a use thereof.

[Brief Description of Drawings]

Figures 1 to 4 are NMR analysis results for polymers prepared in Preparation Examples.

[Mode for Invention]

Hereinafter, the present application will be described in detail through examples, but the scope of the present application is not limited by the following examples.

**1. Polymer structure, component, and component ratio analysis method**

Analyses of a structure, components, and a component ratio of a polymer were performed through HR-MAS (high resolution magic angle spinning) 1H NMR, 1H-13C HSQC (Heteronuclear Single Quantum Coherence) NMR, and 1H-1H COSY (Correlation Spectroscopy) NMR.

**2. Surface resistance measurement**

Surface resistance of a pressure-sensitive adhesive layer was measured under conditions of a temperature of 25°C and 40% relative humidity. The surface resistance was measured using Mitsubishi Chemical's HIRESTA-UP (MCP-HT450) after applying a voltage of 500V for 10 seconds under the above temperature and relative humidity.

**3. Contamination resistance evaluation**

After measuring the surface resistance, Contamination resistance was evaluated by visually observing the surface condition of the pressure-sensitive adhesive layer to determine whether contamination due to static electricity occurred in the pressure-sensitive adhesive layer.

The evaluation criteria for the contamination resistance are as follows.

<Evaluation criteria for contamination resistance>

O: No contamination was confirmed on the surface of the pressure-sensitive adhesive layer

X: Contamination was confirmed on the surface of the pressure-sensitive adhesive layer

**4. Reworkability evaluation**

Reworkability was evaluated by attaching a pressure-sensitive adhesive layer to an adherend, and then peeling it off, and observing the surface condition of the peeled pressure-sensitive adhesive layer. Here, a glass substrate was used as the adherend, and the peeling was performed at a peeling angle of about 180 degrees and a peeling rate of about 300 mm/min.

The evaluation criteria for reworkability are as follows.

<Evaluation criteria for reworkability>

O: No pressure-sensitive adhesive residue was confirmed on the surface of the adherend

Δ: A part of pressure-sensitive adhesive residue was present on the surface of the adherend, making it somewhat cloudy

X: A large amount of pressure-sensitive adhesive residue was present on the surface of the adherend, making it cloudy.

**5. GPC (Gel Permeation Chromatograph)**

A molecular weight was measured using GPC (Gel permeation chromatography). A polymer is placed in a 5 mL vial and diluted in THF (tetrahydro furan) to a concentration of about 1 mg/mL or so. Thereafter, the standard sample for calibration and the sample to be analyzed were filtered through a syringe filter (pore size: 0.45 μm), and then measured. As an analysis program, Agilent technologies' ChemStation was used, and the weight average molecular weight (Mw) and the number average molecular weight (Mn) were each obtained by comparing the elution time of the sample with the calibration curve.

<GPC measurement conditions>

Instrument: Agilent technologies' 1200 series

Columns: Two PLgel mixed B from Polymer laboratories used

Solvent: THF

Column temperature: 35°C

Sample concentration: 1 mg/mL, 200μL injection

Standard sample: polystyrene (Mp: 3900000, 723000, 316500, 52200, 31400, 7200, 3940, 485)

**Preparation Example 1. Preparation of polymer (A)**

To a 1L reactor in which nitrogen gas was refluxed and a cooling device was installed to facilitate temperature adjustment, 2-ethylhexyl acrylate (EHA), methyl methacrylate (MMA), 2-hydroxyethyl acrylate (HEA) and N-vinyl-2-pyrrolidone (NVP) were introduced in a weight ratio of 75:10:10:5 (EHA: MMA: HEA: NVP), and ethyl acetate (EAc) was introduced as a solvent. The solvent was introduced in an amount of about 50 to 60 parts by weight relative to 100 parts by weight of all the monomers. Subsequently, nitrogen gas was purged to remove oxygen, and then azobisisobutyronitrile (AIBN) as a reaction initiator was introduced at a temperature of 65°C to initiate the reaction. The reaction initiator was introduced in an amount of about 300 ppm or so.

The polymerization reaction proceeded for about 5 to 6 hours, and was completed at the time point when the conversion rate reached about 90% or more or so, and a polymer (A) was obtained.

The conversion rate is calculated by Equation 1 below.

[Equation 1]

$$\text{Conversion rate (\%)} = (C/B)/A \times 100$$

In Equation 1, A is the solid content of the monomer mixture, B is the weight (unit: g) of the polymer before drying after the polymerization reaction, and C is the weight (unit: g) of the polymer after drying after the polymerization reaction.

In Equation 1, A is the ratio (=W2/W1) of the weight of the monomer (W2) to the total weight (W1) of the monomer mixture (including solvent and monomer), and the weight (B) of the polymer before drying is the weight of the polymer measured after polymerizing the mixture containing the solvent and the monomer.

In addition, the drying for measuring the weight (C) was performed by maintaining the polymer at a temperature of about 150°C for 30 minutes or so.

The weight average molecular weight (Mw) of the polymer (A) was about 600,000 or so, and the number average molecular weight (Mn) was about 100,000 or so.

**Preparation Example 2. Preparation of polymer (B)**

To a 1L reactor in which nitrogen gas was refluxed and a cooling device was installed to facilitate temperature adjustment, butyl acrylate (BA) and 2-(dimethylamino)ethyl acrylate (DMAEA) were introduced in a weight ratio of 60:40 (BA: DMAEA), and ethyl acetate (EAc) was introduced as a solvent to prepare a monomer mixture. The solvent was introduced in an amount of about 50 to 60 parts by weight relative to 100 parts by weight of the total monomer. Subsequently, nitrogen gas was purged to remove oxygen, and then azobisisobutyronitrile (AIBN) as a reaction initiator was introduced at 65°C to initiate the polymerization reaction. The reaction initiator was introduced in an amount of about 400 ppm.

The polymerization reaction proceeded until the time point when the conversion rate reached 90% or more to obtain a primary polymer (primary polymerization product). The conversion rate is obtained in the same manner as in Preparation Example 1.

To the primary polymerization product, 1 equivalent of bromoethane relative to 2-(dimethylamino)ethyl acrylate (DMAEA) contained in the polymerization product was introduced, and the reaction proceeded at 80°C for an additional 20 hours to obtain the target polymer (B).

The weight average molecular weight (Mw) of the obtained polymer (B) was about 50,000 or so, and the number average molecular weight (Mn) was about 25,000 or so.

Figures 1 and 2 are views showing NMR analysis results for the primary polymerization product and the polymer (B), where Figure 1 is the results for the primary polymer, and Figure 2 is the results for the final polymer (B).

Through Figures 1 and 2, it could be confirmed that the 2-(dimethylamino)ethyl acrylate (DMAEA) unit was changed to the unit of Formula A below through the reaction with bromoethane.

[Formula A]

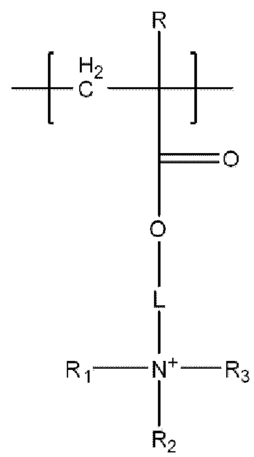

In Formula A, R is hydrogen, L is an ethylene group, $R_1$ and $R_3$ are methyl groups, and $R_2$ is an ethyl group.
Table 1 below is the results of confirming the weight ratios of polymerization units included in the polymer during the above manufacturing process, where BA, DMAEA, and Formula A are ratios of butyl acrylate, 2-(dimethylamino)ethyl acrylate, and the unit of Formula A, respectively.

[Table 1]

| | BA | DMAEA | Formula A |
|---|---|---|---|
| Primary polymer | 59.9 | 40.1 | |
| Polymer (B) | 58.4 | 6.3 | 35.3 |

**Preparation Example 3. Preparation of polymer (C)**

To a 1L reactor in which nitrogen gas was refluxed and a cooling device was installed to facilitate temperature adjustment, butyl acrylate (BA) and 2-(diethylamino)ethyl acrylate (DEAEA) were introduced in a weight ratio of 60:40 (BA: DEAEA), and ethyl acetate (EAc) was introduced as a solvent to prepare a monomer mixture. The solvent was introduced in an amount of about 50 to 60 parts by weight relative to 100 parts by weight of the total monomer. Subsequently, nitrogen gas was purged to remove oxygen, and then azobisisobutyronitrile (AIBN) as a reaction initiator was introduced at 65°C to initiate the polymerization reaction. The reaction initiator was introduced in an amount of about 400 ppm.
The polymerization reaction proceeded until the time point when the conversion rate reached 90% or more to obtain a primary polymer (primary polymerization product). The conversion rate was confirmed in the same manner as Preparation Example 2.
To the obtained primary polymerization product, 1 equivalent of bromoethane relative to 2-(diethylamino)ethyl acrylate (DEAEA) contained in the polymerization product was introduced, and the reaction proceeded at 80°C for an additional 20 hours to obtain the target polymer (C).
The weight average molecular weight (Mw) of the obtained polymer (C) was about 60,000 or so, and the number average molecular weight (Mn) was about 25,000 or so.
Figures 3 and 4 are views showing NMR analysis results for the primary polymerization product and the polymer (C), where Figure 3 is the results for the primary polymer, and Figure 4 is the results for the final polymer (C).
Through Figures 3 and 4, it could be confirmed that the 2-(diethylamino)ethyl acrylate (DEAEA) unit was changed to the unit of Formula B below through the reaction with bromoethane.

[Formula B]

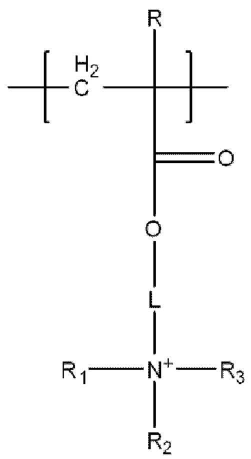

In Formula B, R is hydrogen, L is an ethylene group, and $R_1$ to $R_3$ are ethyl groups.
Table 2 below is the results of confirming the weight ratios of polymerization units included in the polymer during the above manufacturing process, where BA, DEAEA, and Formula B are ratios of butyl acrylate, 2-(diethylamino)ethyl acrylate, and the unit of Formula B, respectively.

[Table 2]

| | BA | DEAEA | Formula B |
|---|---|---|---|
| Primary polymer | 62.4 | 37.6 | 0.0 |
| Polymer (B) | 58.1 | 8.5 | 33.4 |

**Preparation Example 4. Preparation of polymer (D)**

A polymer (D) was produced in the same manner as in Example 1, except that as monomers, 2-ethylhexyl acrylate (EHA), 2-hydroxyethyl acrylate (HEA), and N-vinyl-2-pyrrolidone (NVP) were used in a weight ratio of 85:10:5 (EHA: HEA: NVP).

**Preparation Example 5. Preparation of polymer (E)**

A polymer (E) was produced in the same manner as in Example 1, except that as monomers, 2-ethylhexyl acrylate (EHA), methyl methacrylate (MMA), and 2-hydroxyethyl acrylate (HEA) were used in a weight ratio of 80:10:10 (EHA: MMA: HEA).

**Example 1**

A polymer mixture was prepared by mixing the polymer (A) of Preparation Example 1 and the polymer (B) of Preparation Example 2 in a weight ratio (A: B) of 95:5.

Subsequently, about 0.25 parts by weight of a cross-linking agent (DR-7030HD, Samyoung Ink) and about 3 parts by weight of acetyl acetone were formulated , relative to 100 parts by weight of the solid content of the polymer mixture, diluted to an appropriate concentration, and mixed uniformly to prepare a pressure-sensitive adhesive composition.

Subsequently, the pressure-sensitive adhesive composition was coated on a release paper and maintained at a temperature of 120°C for about 4 minutes and 30 seconds to prepare a pressure-sensitive adhesive layer with a thickness of 100 μm or so.

**Example 2**

A pressure-sensitive adhesive composition and a pressure-sensitive adhesive layer were prepared in the same manner as in Example 1, except that when preparing the polymer mixture, the polymer (A) of Preparation Example 1 and the polymer (B) of Preparation Example 2 were mixed in a weight ratio (A: B) of 90:10.

**Example 3**

A pressure-sensitive adhesive composition and a pressure-sensitive adhesive layer were prepared in the same manner as in Example 1, except that when preparing the polymer mixture, the polymer (A) of Preparation Example 1 and the polymer (B) of Preparation Example 2 were mixed in a weight ratio (A: B) of 80:20.

**Example 4**

A pressure-sensitive adhesive composition and a pressure-sensitive adhesive layer were prepared in the same manner as in Example 1, except that when preparing the polymer mixture, the polymer (A) of Preparation Example 1 and the polymer (B) of Preparation Example 2 were mixed in a weight ratio (A: B) of 70:30.

**Example 5**

A pressure-sensitive adhesive composition and a pressure-sensitive adhesive layer were prepared in the same manner as in Example 1, except that the polymer (C) of Preparation Example 3 was used instead of the polymer (B) of Preparation Example 2.

**Example 6**

A pressure-sensitive adhesive composition and a pressure-sensitive adhesive layer were prepared in the same

manner as in Example 2, except that the polymer (C) of Preparation Example 3 was used instead of the polymer (B) of Preparation Example 2.

**Example 7**

A pressure-sensitive adhesive composition and a pressure-sensitive adhesive layer were prepared in the same manner as in Example 3, except that the polymer (C) of Preparation Example 3 was used instead of the polymer (B) of Preparation Example 2.

**Example 8**

A pressure-sensitive adhesive composition and a pressure-sensitive adhesive layer were prepared in the same manner as in Example 4, except that the polymer (C) of Preparation Example 3 was used instead of the polymer (B) of Preparation Example 2.

**Comparative Example 1**

About 3 parts by weight of FeAA (Ferric Acetyl Acetonate) and about 0.25 parts by weight of an isocyanate compound (DR-7030HD, Samyoung Ink) were formulated relative to 100 parts by weight of the polymer (A) of Preparation Example 1, and about 0.05 parts by weight of an antistatic agent (Lithium Bis(Trifluoromethanesulfonyl)imide) was formulated relative to 100 parts by weight of the polymer (A), and then a pressure-sensitive adhesive composition was prepared by diluting the mixture to an appropriate concentration and then mixing it uniformly.
Subsequently, the pressure-sensitive adhesive composition was coated on a release paper and maintained at a temperature of 120°C for about 4 minutes and 30 seconds to prepare a pressure-sensitive adhesive layer with a thickness of less than 100 μm or so.

**Comparative Example 2**

About 3 parts by weight of FeAA (Ferric Acetyl Acetonate) and about 0.25 parts by weight of an isocyanate compound (DR-7030HD, Samyoung Ink) were formulated relative to 100 parts by weight of the polymer (A) of Preparation Example 1, and about 0.15 parts by weight of an antistatic agent (Lithium Bis(Trifluoromethanesulfonyl)imide) was formulated relative to 100 parts by weight of the polymer (A), and then a pressure-sensitive adhesive composition was prepared by diluting the mixture to an appropriate concentration and then mixing it uniformly.
Subsequently, the pressure-sensitive adhesive composition was coated on a release paper and maintained at a temperature of 120°C for about 4 minutes and 30 seconds to prepare a pressure-sensitive adhesive layer with a thickness of less than 100 μm or so.

**Comparative Example 3**

A pressure-sensitive adhesive composition and a pressure-sensitive adhesive layer were prepared in the same manner as in Comparative Example 1, except that the polymer (D) of Preparation Example 4 was used instead of the polymer (A) of Preparation Example 1.

**Comparative Example 4**

A pressure-sensitive adhesive composition and a pressure-sensitive adhesive layer were prepared in the same manner as in Comparative Example 2, except that the polymer (D) of Preparation Example 4 was used instead of the polymer (A) of Preparation Example 1.

**Comparative Example 5**

A pressure-sensitive adhesive composition and a pressure-sensitive adhesive layer were prepared in the same manner as in Comparative Example 1, except that the polymer (E) of Preparation Example 5 was used instead of the polymer (A) of Preparation Example 1.

**Comparative Example 6**

A pressure-sensitive adhesive composition and a pressure-sensitive adhesive layer were prepared in the same

manner as in Comparative Example 2, except that the polymer (E) of Preparation Example 5 was used instead of the polymer (A) of Preparation Example 1.

The evaluation results for Examples and Comparative Examples above were summarized and described in Tables 3 and 4 below.

[Table 3]

| | Example | | | | | | | |
|---|---|---|---|---|---|---|---|---|
| | 1 | 2 | 3 | 4 | 5 | 6 | 7 | 8 |
| Surface resistance ($\times 10^{12}$ Ω/□) | 65.4 | 22.8 | 6.43 | 2.88 | 38.1 | 1.7 | 1.46 | 0.383 |
| Contamination resistance | O | O | O | O | O | O | O | O |
| Reworkability | O | O | O | O | O | O | O | O |

[Table 4]

| | Comparative Example | | | | | |
|---|---|---|---|---|---|---|
| | 1 | 2 | 3 | 4 | 5 | 6 |
| Surface resistance ($\times 10^{12}$ Ω/□) | 65.1 | 7.04 | 75.9 | 7.12 | 69.1 | 7.47 |
| Contamination resistance | X | O | X | O | Δ | O |
| Reworkability | Δ | X | X | X | Δ | X |

From Table 3, it can be confirmed that the pressure-sensitive adhesive compositions according to the present application exhibits appropriate surface resistance, contamination resistance, and reworkability. Particularly, it can be confirmed that more appropriate surface resistance is exhibited when the polymer of Preparation Example 3 is included.

## Claims

1. A polymer comprising an alkyl (meth)acrylate unit and a unit of Formula 1 below, and comprising the unit of Formula 1 in an amount of 20 parts by weight or more relative to 100 parts by weight of the alkyl (meth)acrylate unit:

[Formula 1]

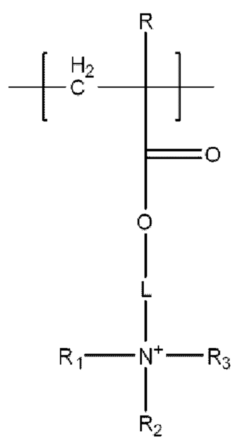

wherein, L is an alkylene group or an alkylidene group, R is a hydrogen atom or an alkyl group, and $R_1$ to $R_3$ are alkyl groups.

2. The polymer according to claim 1, comprising the alkyl (meth)acrylate unit in a ratio of 30 to 80 wt%.

3. The polymer according to claim 1, further comprising a unit of Formula 2 below:

[Formula 2]

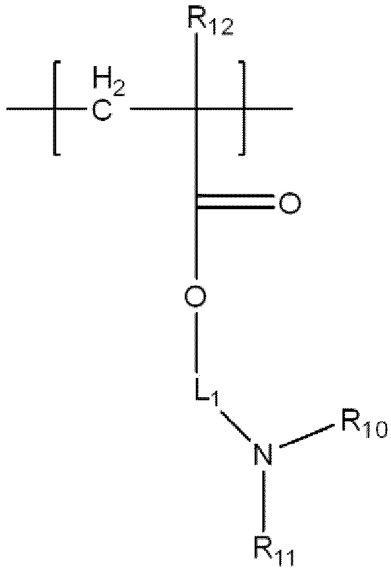

wherein, $L_1$ is an alkylene group or an alkylidene group, $R_{12}$ is a hydrogen atom or an alkyl group, and $R_{10}$ and $R_{11}$ are each independently an alkyl group.

4. The polymer according to claim 3, comprising the unit of Formula 2 in an amount of 0.1 to 30 parts by weight relative to 100 parts by weight of the alkyl (meth)acrylate unit.

5. The polymer according to claim 3, wherein the ratio (A/B) of the weight (A) of the unit of Formula 1 to the weight (B) of the unit of Formula 2 is in a range of 0.5 to 20.

6. The polymer according to claim 1, having a weight average molecular weight of 200,000 g/mol or less.

7. A cross-linkable composition comprising:

   a cross-linkable polymer; and
   the polymer of claim 1 as an ionic polymer.

8. The cross-linkable composition according to claim 7, comprising 1 to 60 parts by weight of the ionic polymer relative to 100 parts by weight of the cross-linkable polymer.

9. The cross-linkable composition according to claim 7, wherein the cross-linkable polymer comprises an alkyl (meth) acrylate unit.

10. The cross-linkable composition according to claim 9, wherein the cross-linkable polymer further comprises a unit of Formula 3 below:

[Formula 3]

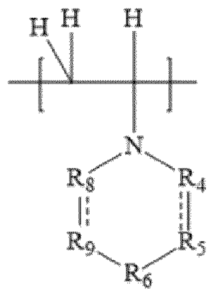

wherein, $R_4$, $R_5$, $R_8$ and $R_9$ are each independently a carbon atom or a carbonyl group, $R_6$ is a carbon atom or an oxygen atom or is not be present, and the bond between $R_4$ and $R_5$ and the bond between $R_8$ and $R_9$ are each independently a single bond or a double bond.

**11.** The cross-linkable composition according to claim 10, wherein in Formula 3, $R_4$, $R_5$, $R_8$ and $R_9$ are each independently a carbon atom or a carbonyl group, $R_6$ is a carbon atom or not present, and the bond between $R_4$ and $R_5$ and the bond between $R_8$ and $R_9$ are each independently a single bond or a double bond, but at least one of $R_4$, $R_5$, $R_8$ and $R_9$ is a carbonyl group.

**12.** The cross-linkable composition according to claim 10, wherein the cross-linkable polymer comprises the unit of Formula 3 in an amount of 0.5 to 20 parts by weight relative to 100 parts by weight of the alkyl (meth)acrylate unit.

**13.** The cross-linkable composition according to claim 9, wherein the cross-linkable polymer further contains a polar group-containing unit.

**14.** The cross-linkable composition according to claim 13, wherein the cross-linkable polymer comprises the polar group-containing unit in an amount of 1 to 30 parts by weight relative to 100 parts by weight of the alkyl (meth)acrylate unit.

**15.** The cross-linkable composition according to claim 7, further comprising a cross-linking agent and a cross-linking retardant.

**16.** The cross-linkable composition according to claim 15, wherein the cross-linking agent is included in a ratio of 0.01 to 10 parts by weight relative to 100 parts by weight of the total cross-linkable and ionic polymers, and the cross-linking retardant is included in an amount of 0.1 to 10 parts by weight relative to 100 parts by weight of the total cross-linkable and ionic polymers, and the ratio (A/B) of the weight (A) of the cross-linking retardant to the weight (B) of the cross-linking agent is in a range of 0.5 to 30.

**17.** A method for preparing the cross-linkable composition of claim 7, comprising: a step of mixing a cross-linkable polymer and an ionic polymer, wherein
the ionic polymer is produced by a method comprising steps of:

reacting a monomer mixture containing an alkyl (meth)acrylate and a compound of Formula 4 below to obtain a polymer; and
reacting the polymer with a haloalkane:

[Formula 4]

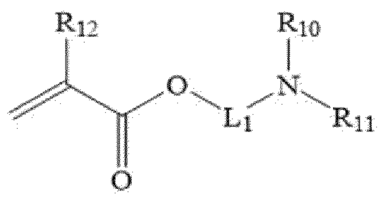

wherein, $L_1$ is an alkylene group or an alkylidene group, $R_{12}$ is a hydrogen atom or an alkyl group, and $R_{10}$ and $R_{11}$ are each independently an alkyl group.

**18.** The method for producing a polymer according to claim 17, wherein the reaction of the monomer mixture is a solution polymerization reaction.

**19.** A laminate comprising:

an electronic substrate; and
the cross-linkable composition of claim 7 or a cross-linked product thereof attached to one or both sides of the electronic substrate.

**20.** An OLED device comprising:

an OLED panel; and
the cross-linkable composition of claim 7 or a cross-linked product thereof attached to one or both sides of the OLED panel.

[Figure 1]

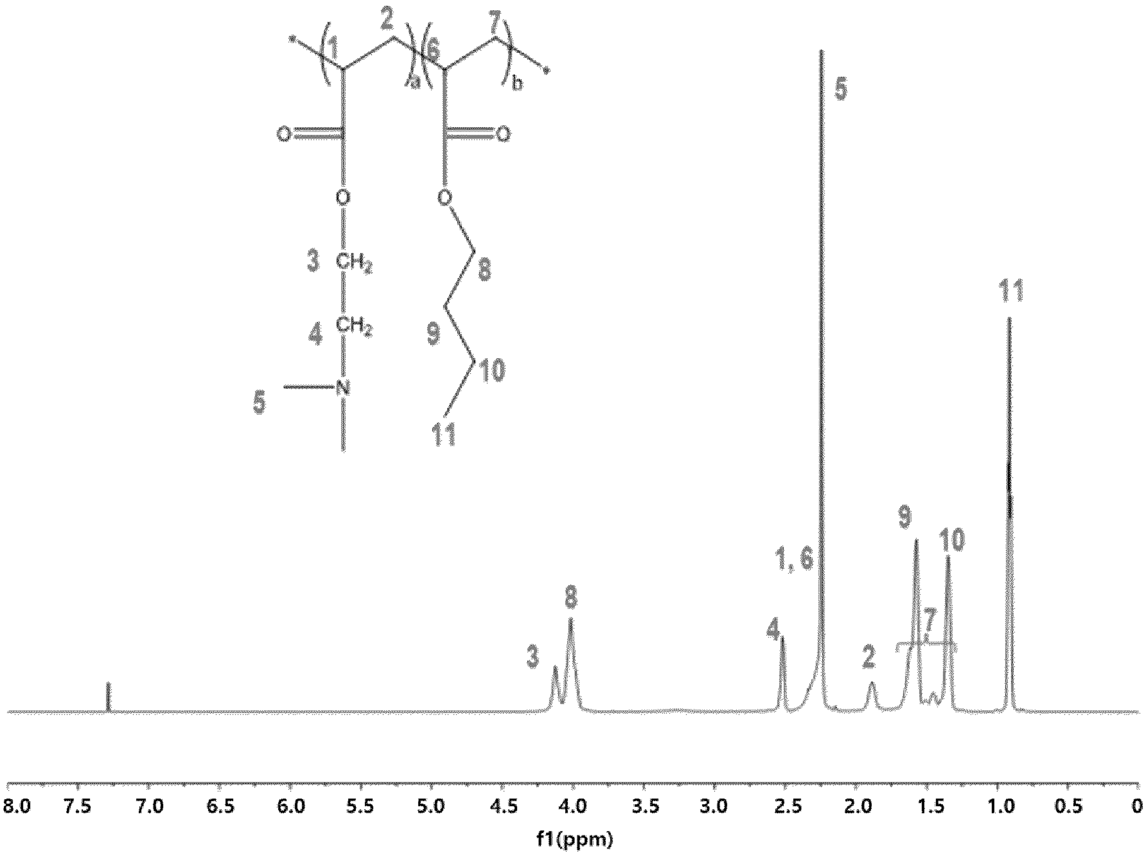

[Figure 2]

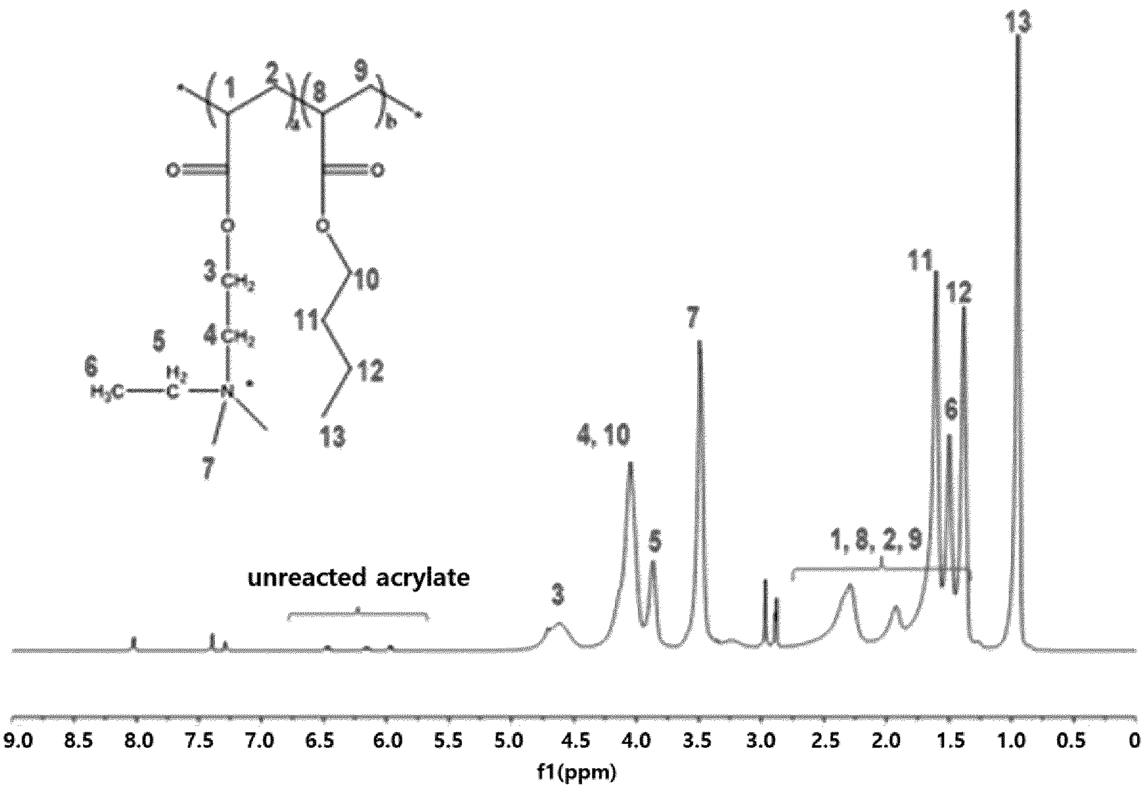
13
11
12
7
4, 10
6
5
1, 8, 2, 9
unreacted acrylate
3
9.0 8.5 8.0 7.5 7.0 6.5 6.0 5.5 5.0 4.5 4.0 3.5 3.0 2.5 2.0 1.5 1.0 0.5 0
f1(ppm)

[Figure 3]

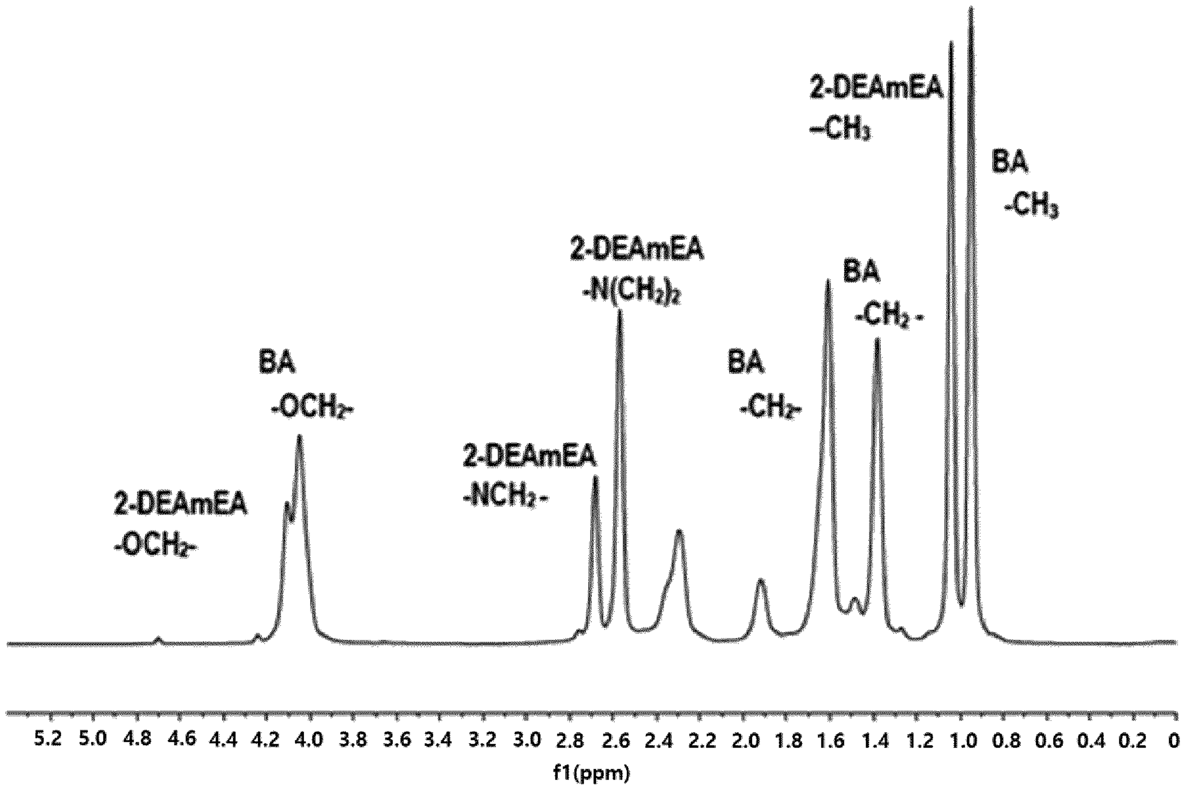
2-DEAmEA
-CH3
BA
-CH3
2-DEAmEA
-N(CH2)2
BA
-CH2-
BA
-OCH2-
BA
-CH2-
2-DEAmEA
-NCH2-
2-DEAmEA
-OCH2-
5.2 5.0 4.8 4.6 4.4 4.2 4.0 3.8 3.6 3.4 3.2 3.0 2.8 2.6 2.4 2.2 2.0 1.8 1.6 1.4 1.2 1.0 0.8 0.6 0.4 0.2 0
f1(ppm)

[Figure 4]

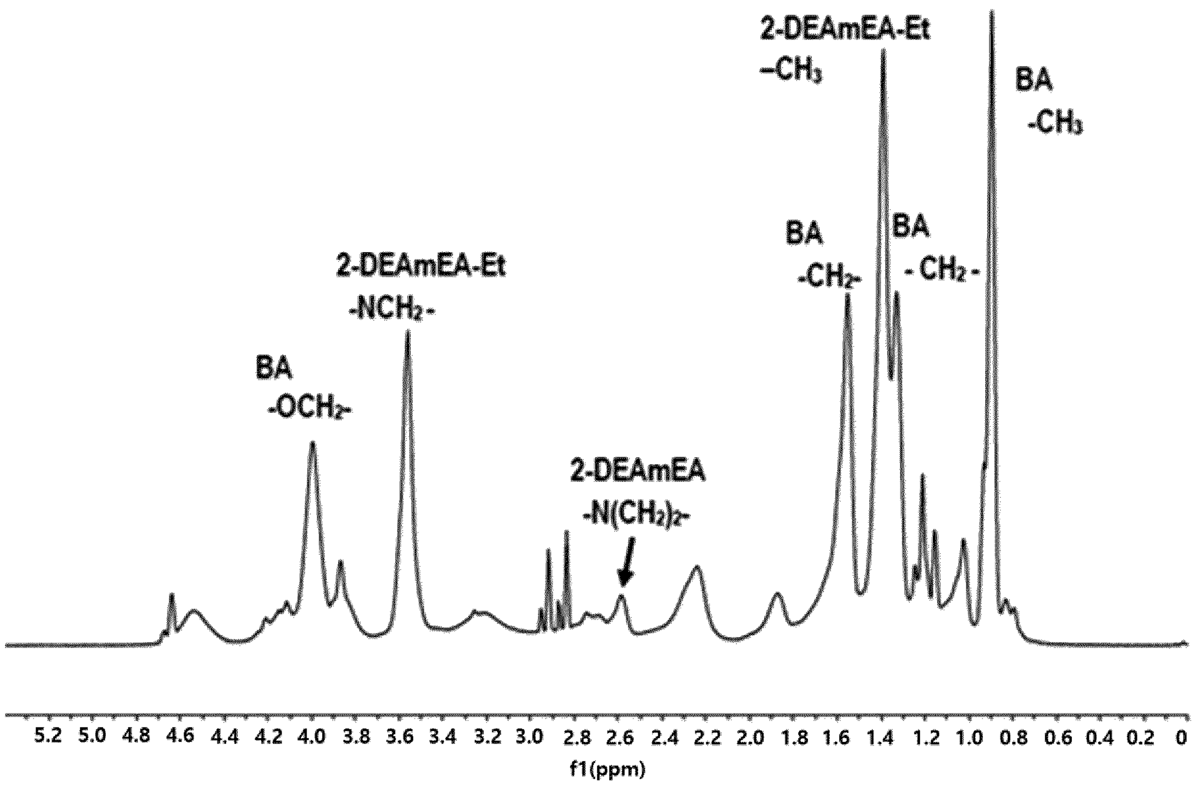
2-DEAmEA-Et
–CH3
BA
-CH3
BA
-CH2-
BA
- CH2 -
2-DEAmEA-Et
-NCH2 -
BA
-OCH2-
2-DEAmEA
-N(CH2)2-
5.2 5.0 4.8 4.6 4.4 4.2 4.0 3.8 3.6 3.4 3.2 3.0 2.8 2.6 2.4 2.2 2.0 1.8 1.6 1.4 1.2 1.0 0.8 0.6 0.4 0.2 0
f1(ppm)

**INTERNATIONAL SEARCH REPORT**

International application No.
**PCT/KR2023/016044**

**A. CLASSIFICATION OF SUBJECT MATTER**

**C08F 220/34**(2006.01)i; **C08F 226/06**(2006.01)i; **C09J 133/14**(2006.01)i; **H01L 23/29**(2006.01)i; **H10K 59/00**(2023.01)i; **H10K 50/00**(2023.01)i

According to International Patent Classification (IPC) or to both national classification and IPC

**B. FIELDS SEARCHED**

Minimum documentation searched (classification system followed by classification symbols)

C08F 220/34(2006.01); C07C 68/06(2006.01); C07C 69/96(2006.01); C08F 212/08(2006.01); C08F 226/06(2006.01); C09B 67/20(2006.01); C09B 67/46(2006.01); C09J 133/04(2006.01); C09J 175/04(2006.01); G02B 1/10(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, CAplus) & keywords: 양이온성 중합체(cationic polymer), 가교성 중합체 (crosslinkable polymer), 대전방지성 점착제(antistatic adhesive)

**C. DOCUMENTS CONSIDERED TO BE RELEVANT**

| Category* | Citation of document, with indication, where appropriate, of the relevant passages | Relevant to claim No. |
|---|---|---|
| X<br>A | KR 10-2010-0046016 A (3M INNOVATIVE PROPERTIES COMPANY) 04 May 2010 (2010-05-04)<br>See claims 1 and 18; paragraph [0042]; and table 1. | 1-6<br>7-20 |
| X | CN 111635478 A (ZHUHAI GUANYU BATTERY CO., LTD.) 08 September 2020 (2020-09-08)<br>See claims 1 and 4; and paragraphs [0028] and [0029]. | 1-6 |
| X | JP 2015-110712 A (TOYO INK SC HOLDINGS CO., LTD.) 18 June 2015 (2015-06-18)<br>See paragraphs [0065] and [0180]-[0183]; and table 1 (polymer S-19). | 1-6 |
| A | CN 113004147 A (INSTITUTE OF PROCESS ENGINEERING, CHINESE ACADEMY OF SCIENCES) 22 June 2021 (2021-06-22)<br>See entire document. | 1-20 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **01 February 2024** | **02 February 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.
**PCT/KR2023/016044**

**C. DOCUMENTS CONSIDERED TO BE RELEVANT**

| Category* | Citation of document, with indication, where appropriate, of the relevant passages | Relevant to claim No. |
|---|---|---|
| A | KR 10-2013-0113372 A (FUJIMORI KOGYO CO., LTD.) 15 October 2013 (2013-10-15)<br>See entire document. | 1-20 |

Form PCT/ISA/210 (second sheet) (July 2022)

**INTERNATIONAL SEARCH REPORT**
**Information on patent family members**

International application No.
**PCT/KR2023/016044**

| Patent document cited in search report | Publication date (day/month/year) | Patent family member(s) | Publication date (day/month/year) |
|---|---|---|---|
| KR 10-2010-0046016 A | 04 May 2010 | CN 101809110 A | 18 August 2010 |
| | | CN 101809110 B | 19 March 2014 |
| | | EP 2178998 A2 | 28 April 2010 |
| | | EP 2178998 B1 | 05 March 2014 |
| | | JP 2010-534272 A | 04 November 2010 |
| | | JP 5426546 B2 | 26 February 2014 |
| | | KR 10-1494033 B1 | 16 February 2015 |
| | | TW 200920829 A | 16 May 2009 |
| | | US 2009-0029129 A1 | 29 January 2009 |
| | | US 2013-0236702 A1 | 12 September 2013 |
| | | US 8449970 B2 | 28 May 2013 |
| | | US 9260612 B2 | 16 February 2016 |
| | | WO 2009-014897 A2 | 29 January 2009 |
| | | WO 2009-014897 A3 | 19 March 2009 |
| CN 111635478 A | 08 September 2020 | CN 111635478 B | 14 June 2022 |
| JP 2015-110712 A | 18 June 2015 | None | |
| CN 113004147 A | 22 June 2021 | CN 113004147 B | 22 April 2022 |
| KR 10-2013-0113372 A | 15 October 2013 | CN 103361010 A | 23 October 2013 |
| | | CN 103361010 B | 14 October 2015 |
| | | JP 2013-216738 A | 24 October 2013 |
| | | JP 5909137 B2 | 26 April 2016 |
| | | KR 10-1511079 B1 | 10 April 2015 |
| | | TW 201343835 A | 01 November 2013 |
| | | TW I495699 B | 11 August 2015 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020220133526